# EUROPEAN PATENT APPLICATION

(11) **EP 4 276 222 A1**
(43) Date of publication of application: **15.11.2023**
(21) Application number: 22172883.5
(22) Date of filing: 12.05.2022
(51) Int. Cl.: C25B 1/04, H01L 31/043, H01L 31/078

(54) **ELECTROLYSER COMPRISING A MULTIPLE-JUNCTION PHOTOVOLTAIC CELL**

(71) Applicant: Siemens Energy Global GmbH & Co. KG, 81739 München (DE)
(72) Inventor: Fleischer, Maximilian, 85635 Höhenkirchen (DE); Thiemann, Thomas, 45659 Recklinghausen (DE)

(57) **Abstract**

The present invention relates to an electrolyser (10a, 10b) comprising an electrolysis assembly (12) having an electrolysis cell (14) configured to generate an electrolysis product (16) from a supply medium (18). Further, the electrolyser (10a, 10b) comprises a multi-junction photovoltaic cell (20) having multiple p-n junctions (22, 23) and a regulation assembly (24a, 24b) having an electric power converter (26) configured to convert (102) at least a part of the electrical energy generated (104) by the multi-junction photovoltaic cell (20) according to requirements of the electrolysis assembly (12) so as to provide an energy supply for the electrolysis assembly (12).

## Description

The present invention relates to a generation of an electrolysis product, in particular to an electrolyser, a system comprising the electrolyser, a method for generating an electrolysis product and a method for operating the system.

Electrolysis is a widely known electro-chemical method, wherein a direct (electrical) current (DC) is used to drive an otherwise non-spontaneous chemical reaction. It has gotten recent attention as a factor in fighting against climate change, as it may be utilised in so-called "power to X" processes or as chemical feedstock in various applications. In said processes, a supply medium (such as water or CO₂) is generally converted by means of electrical energy into chemical energy containing substances via electrolysis. The electrolysis products containing this energy range from e.g. hydrogen H₂ (with O₂ as by-product) over small hydrocarbons like methane CH₄ (also termed "synthetic natural gas" SNG or synthetic LNG in its liquid form), Ethylene C₂H₄ or Ethanol C₂H₅OH to ammonia NH₃ or carbon monoxide CO. Said molecules may be used as fuel, e.g. for vehicles or generators, or as feedstock for the chemical industry.

A currently established industrial procedure is to generate renewable electrical energy, transport this energy via an electrical (public) power grid to an electrolyser and then produce said electrolysis products out of a supply medium, e.g. water H₂O, carbon dioxide CO₂ or nitrogen N₂. This procedure provides the advantage of placing renewable energy plants at locations where enough area is available. However, generation of energy and generation of electrolysis products are spatially decoupled. Thus, an electrical public power grid in combination with multiple energy converters are needed to operate corresponding electrolysis cells by means of renewable energy. As a consequence, this leads to significant losses in energy as well as high costs for installation and maintenance of infrastructure, e.g. conductor infrastructure and energy conversions means.

It is an object of the present invention to improve an overall efficiency of an electrolysis process and to reduce an overall area footprint.

This object is solved by an electrolyser according to the independent claims.

Furthermore, this object is solved by a system according to the corresponding system claim, a method for generating an electrolysis product according to the corresponding method claim and a method for operating the system in accordance with the corresponding method claim.

Preferred embodiments of the invention are subject of the dependent claims and the following description.

An electrolyser according to the invention comprises an electrolysis assembly, a multi-junction photovoltaic cell and a regulation assembly. Said electrolysis assembly has an electrolysis cell configured to generate an electrolysis product from a supply medium. In particular, the electrolysis cell converts water into H₂ and O_{2;} or CO₂ and water into CO, small hydrocarbons or small oxygenates. The multi-junction photovoltaic cell comprises multiple p-n junctions. Typically, the multi-junction photovoltaic cell comprises two to four p-n junctions, however, can also comprise more p-n junctions. The term p-n junction can be used synonymous to the term n-p junction. Both of said terms have the same technical meaning and only depend on the direction of view. Preferably, said p-n junctions having different energy band gaps. Further, it is possible that the multi-junction photovoltaic cell is made of different semiconductor materials. In a preferred embodiment, the multi-junction photovoltaic cell comprises at least two layers made of different semiconductor materials, wherein in each semiconductor material at least one p-n junction is located. In a further preferred embodiment, the electrolyser comprises a photovoltaic assembly having a plurality of multi-junction photovoltaic cells. Such an assembly comprises typically a plurality of photovoltaic cells assembled to multiple photovoltaic modules. These multiple photovoltaic modules are again typically assembled to one or more photovoltaic arrays. Preferably, at least one of said multiple photovoltaic modules or at least one of said photovoltaic arrays comprise solely multi-junction photovoltaic cells. Especially preferred, all photovoltaic cells used to build up the photovoltaic assembly are multi-junction photovoltaic cells. Further, the regulation assembly has an electric power converter configured to convert at least a part of the electrical energy generated by the multi-junction photovoltaic cell according to requirements of the electrolysis assembly so as to provide an energy supply for the electrolysis assembly. In this context, the conversion of electrical energy according to requirements of the electrolysis assembly means that an electrical current or voltage generated by the multi-junction photovoltaic cell is converted into an electrical current value in a predetermined operating current range and into a voltage in a predetermined operating voltage range of the electrolysis assembly. As the generated electrical energy underlies variations, for example due to weather conditions or seasonal irradiation intensity, also fluctuating operating voltage and/or operating current can be supplied to the electrolysis assembly. In this way, a production of the electrolysis product can be easily correlated to an amount of energy generated by the photovoltaic cell. This leads to the further advantage that a main part of generated energy is directly consumed without the need of storing it. Hence, an energy storing unit or a buffer unit for surplus energy can be designed smaller and compact. Preferably, the regulation assembly is electrically, in particular directly electrically, connected to the multi-junction photovoltaic cell and to the electrolysis assembly. Further, the electrolysis assembly is preferably configured to operate on direct current generated by the multi-junction photovoltaic cell when exposed to electromagnetic radiation, in particular sunlight. This enables, in contrast to conventional solutions where electrical energy is transmitted to an electrolyser via an external power grid, a simple and easy provision of electrical energy to the electrolysis assembly. Especially, the number of components necessary for supplying the electrolysis assembly with power can be reduced. This allows for a gain in efficiency. Further, a footprint area of the electrolyser can be reduced by means of using multi-junction photovoltaic cells utilising a wide range of frequency bands of electromagnetic radiation, in particular the sunlight spectra, to convert electromagnetic energy into electrical energy. Single-junction photovoltaic cells can only harvest a limited part of the sunlight spectra by means of one p-n junction having a predefined energy band gap. This limits their efficiency defined as the electrical power output divided by a total energy input coming from the irradiation of the sun. A typical efficiency of such a single-junction photovoltaic cells receives 25%-27% in practical applications. Instead, multi-junction photovoltaic cells are able to convert a wider range of the irradiation of the sunlight's spectra into electrical energy. In this way, said efficiency can be augmented above 30%, in particular applications up to 40%-50%. A typical efficiency value of a multi-junction photovoltaic cell is at about 33%-38%. Hence, more electrical energy can be obtained per area unit, leading to a reduction of the size of the footprint area required for generation of electrical energy to operate an electrolysis cell. Typical reductions of the footprint area achieved by means of using multi-junction photovoltaic cells lies in the range of 10% to 50%. Preferred is a reduction of 15%-30%. This enables to install an electrolyser in regions, where area for installation of an electrolyser is scarce and/or expensive. Examples for such regions are heavily populated areas with high local demand for electrolysis product, regions where land is fertile and needed for agriculture or regions which are strongly corrugated like mountain regions, where it is difficult to find sufficient area to install photovoltaic cells in an economic way.

Furthermore, using multi-junction cells helps to secure valuable natural resources such as agricultural areas for food production or forests for climate regulation.

In addition, the exploitation of different spectral parts of the irradiated sunlight during a course of a day helps to improve the overall efficiency of the electrolyser further. In particular, a capacity factor of the photovoltaic cells and hence of the electrolyser is improved.

An additional advantage of the reduction of the footprint area of the photovoltaic cells is saving costs for installation and maintaining the photovoltaic cells, due to saving costs for trackers, for cables and/or for cleaning. So the reduction of the footprint area needed for photovoltaic cells directly relates to savings of capital expenditures and operating expenses of the electrolyser.

In an advantageous embodiment, the electrical power converter is a DC/DC-converter configured to convert a voltage generated by the multi-junction photovoltaic cell directly into an operating voltage of the electrolysis assembly. Preferably, said DC/DC-converter is configured to convert an electrical current generated by the multi-junction photovoltaic cell directly into an operating current of the electrolysis assembly. In this way, energy losses due to power conversion, especially DC-AC-DC-conversion, can be reduced or even avoided. Additionally, energy losses due to long distance transportation via an external power grid can be avoided, too. This leads advantageously, to a less need of expensive wires, e.g. a need of copper is reduced. Further, a positioning of the components of the electrolyser in direct proximity to each other is enabled. In particular, the DC/DC-converter is configured to convert said generated voltage into an operating voltage within a corresponding operating value range and said generated electrical current into an electrical current within a corresponding operating value range.

In another advantageous embodiment, the multi-junction photovoltaic cell comprises perovskite as a semiconductor material. By this means, a ratio of size of a photovoltaic cell to power of the photovoltaic cell can be reduced. Consequently, a required footprint area for installation of the electrolyser can be reduced and an efficiency of the photovoltaic cells can be improved.

In a further advantageous embodiment, the multi-junction photovoltaic cell comprises at least one semiconductor material from the following group of: cadmium telluride (CdTe), copper indium gallium (di)selenide (CIGS), copper indium selenide (CIS), microcrystalline silicon (µc-Si) or amorphous Si (a-Si). This enables to convert a wide energy range of the spectra of the sunlight into electrical energy. In this way, a yield of the photovoltaic cell can be augmented. Additionally, a size to power ratio can further be improved. Particularly, crystalline silicon is used as a bulk semiconductor material. By this means, an easy to manufacture and commonly available photovoltaic cell can be used.

In an advantageous development, at least one of the different semiconductor materials is provided as a thin film layer. A thin film is a layer of material ranging from fractions of a nanometer, e.g. a monolayer, to several micrometer in thickness. A typical thin film thickness in photovoltaic applications ranges from inclusive 1 micrometer to inclusive 5 micrometer.

Furthermore, preferably at least one p-n junction of the multi-junction photovoltaic cell is located in a semiconductor material comprising quantum dots. A typical semiconductor material for the purpose of manufacturing quantum dots is for example silicon, germanium or compound semiconductors, as CdSe, PbSe, CdTe and/or PbS. In this way, a yield of electrical energy converted from sunlight can further be optimized.

In a preferred embodiment, the multi-junction photovoltaic cell has two p-n junctions. A first of said two p-n junctions is located in a semiconductor material comprising crystalline silicon. Further, a second of said two p-n junctions is located in a semiconductor material comprising perovskite. By means of this combination of different semiconductor materials, a particularly efficient electrolyser can be realised with a significantly reduced footprint area.

In yet another advantageous embodiment, the electrolysis cell has a load profile according to which the load of the electrolysis cell is adjustable between a first operating state at 10% of a power rating of said electrolysis cell and a second operating state at 100% of the power rating of said electrolysis cell within 10 s. Said power rating is to be understood in the sense of electrical engineering. In this context, the power rating is the highest peak electrical power input allowed to be supplied for continuous operation of the corresponding equipment. For example, said load profile can be realised by means of an electrolysis cell having a proton-exchange membrane. Another example for realising said load profile is an electrolysis cell having an anion-exchange membrane, wherein the electrolysis electrodes are directly deposited at the conducting membrane. In contrast to classical electrolysis cells, e.g. such using alkaline electrolysis, the proton-exchange membrane or anion-exchange membrane enables a fast adaption of a production rate to a variating supply energy. In particular, the electrolysis cell is adaptable between the first and the second operating state within 6s and preferably within 2s. In this way, the operating state of the electrolysis cell is capable to follow a fluctuating energy generation of the multi-junction photovoltaic cell. Hence, the electrolysis cells are capable to consume almost instantly the most part of generated electrical energy. This also allows to build up an energy management with small dimensions and by means of ordinary and cheap components. Especially, due to the direct consumption of a great part of generated energy, expensive and large-scale batteries for the purpose of storing excess energy become superfluous. In this way, small and commonly available energy storing units can be used.

In a further advantageous embodiment, the electrolysis assembly comprises at least one downstream electrolysis cell configured to generate a higher chemical energy containing electrolysis product on the base of a lower chemical energy containing electrolysis product. This allows in the case of high energy production by means of the multi-junction photovoltaic cell or the photovoltaic assembly to directly convert an excess energy in raising a chemical energy level of the already generated electrolysis product. Such electrolysis products with higher chemical energy level are for example ammonia, methanol or methane, which can be used e.g. as fuel. A waste of excess energy, especially in case of an autonomous electrolyser, can be avoided.

In another advantageous embodiment, the regulation assembly has an energy storage unit configured to store at least a part of the electrical energy generated by the multi-junction photovoltaic cell and to provide at least a part of the stored electrical energy to the electrolysis assembly. The energy storage unit is preferably configured to store at least a part of the electrical energy provided by the photovoltaic assembly in a first operating mode and to provide the electrolysis assembly with at least a part of the stored electrical energy in a second operating mode. For example, the energy storage unit may be used to provide protective voltages for maintaining stability and proper function of the electrolysis assembly at all times, in particular during night. Such an energy storage unit thus enables substantially sustained, especially power grid independent operation (also termed "island operation") of the electrolyser. For example, the electrolyser might be deployed in sun rich regions with little infrastructure, e.g. in deserts or on offshore installations. In this context, it is also advantageous that an effort, e.g. in terms of component parts and costs, associated to connecting the electrolysis assembly to a power grid can be saved.

Also, the provision of an energy storage unit allows for efficient use of the generated electrical energy. If the electrical power generated by the multi-junction photovoltaic cell, or especially generated by the photovoltaic assembly, exceeds a maximal possible power consumption of the electrolysis assembly, e.g. during time of intensive incident electromagnetic radiation, the excess energy does not have to be wasted, but can be stored instead and used later on for electrolysis or other purposes as being fed into an electrical power grid. Vice versa, if the power generated by the multi-junction photovoltaic cell does not meet the power requirements of the electrolysis assembly, e.g. during unfavourable weather conditions or at dusk or dawn, respectively, the electrolysis assembly can be efficiently operated nevertheless. Preferably, the energy storage unit comprises a storage capacity which allows for substantially continuous operation of the electrolysis assembly, e.g. even during night. For example, the energy storage unit is a battery.

In a further advantageous development, the energy storage unit has a buffer module configured to store at least a part of the electrical energy generated by the multi-junction photovoltaic cell in such that variations in the voltage output generated by the multi-junction photovoltaic cell having a duration time of more than or equal to 10s, preferably more than or equal to 30s, are compensated. Preferably, a duration time having a range of more than or equal to 10s, preferably more than or equal to 30s and of less than or equal to one hour is compensated by means of the buffer module. For example, the buffer module can be a super capacitor. This enables to smooth short term voltage peaks due to fluctuating electrical energy production occurring for example due to changing weather conditions, e.g. cloud movements, shadows or reflections.

In yet another further advantageous embodiment, the regulation assembly is electrically connected to an external power grid and configured to feed at least a part of the electrical energy generated by the multi-junction photovoltaic cell to the power grid and/or to draw electrical energy from the power grid in order to operate the electrolysis assembly. Preferably, the external power grid is a public power grid. In particular, the electrolyser is configured to operate at least partly with electrical energy provided by the external power grid. For example, the regulation assembly may be configured to draw electrical energy from the external power grid in order to provide a protective voltage to the electrolysis assembly when the multi-junction photovoltaic cell is inoperative, e.g. during night, and/or in order to supplement the energy generated by the multi-junction photovoltaic cell. Accordingly, even if the energy generated by the multi-junction photovoltaic cell does not meet the power requirements of the electrolysis assembly, e.g. during unfavourable weather conditions, the electrolysis assembly can be efficiently operated nevertheless. Hence, a production rate can be augmented and waste of excess energy can be avoided. A stop of an operation of the electrolyser in times of low energy production by the multi-junction photovoltaic cell can easily be avoided.

In another advantageous embodiment, the multi-junction photovoltaic cells are arranged above the electrolysis assembly, e.g. on a top side of the electrolysis assembly, or laterally adjacent to the electrolysis assembly. For example, the multi-junction photovoltaic cell may be mounted on a scaffold or at least on posts such that the electrolysis assembly may be arranged directly below the multi-junction photovoltaic cell. By this means, a footprint area can further be reduced as additional installation area for the electrolysis assembly can be cut down. Alternatively, the electrolysis assembly may be arranged laterally around the multi-junction photovoltaic cell. For example, a plurality of multi-junction photovoltaic cells may be arranged in a star arrangement or another similar topology, while the electrolysis assembly being arranged in the middle. By this means, effort and costs for installation and cabling can be reduced.

The system according to the invention comprises the electrolyser according to the invention.

Additionally, said system comprises a peripheral assembly with a plurality of peripheral modules. At least one of said peripheral modules is fed with at least a part of the electrical energy generated by the multi-junction photovoltaic cell of said electrolyser. A peripheral module is for example a compressing unit configured to compress the electrolysis product, a chiller unit for cooling down the compressed electrolysis product, a chiller unit for cooling down the electrolyser, a gas cleaning module configured to clean the electrolysis product, a connecting assembly configured to realise a connection to transportation vehicles or transportation pipelines, or a peripheral storage unit configured to store electrical energy next to or alternatively to the energy storage unit of the electrolyser or configured to store gas or liquid. In this way, a direct and efficient consumption of generated electrical energy by means of the multi-junction photovoltaic cell is enabled. Feeding energy to the external power grid or storing excess energy can be minimized. As a result, a dimension of components of the system can be significantly reduced. Further, in this way an autonomous system can be provided, which can be installed in regions with weak or no infrastructure. Especially, an operation in full island mode is possible.

In an advantageous embodiment, of the system the peripheral assembly comprises said compressing unit configured to compress the electrolysis product generated by the electrolysis assembly. In this context, the regulation assembly of the electrolyser is configured to control said compressing unit in dependence of an amount of electrical energy generated by the multi-junction photovoltaic cell and/or in dependence of the electrical voltage supplied to the electrolysis assembly via said regulation assembly. In this way, an energy supplied to the compression unit is directly linked to a production rate of the electrolysis assembly. Hence, the operating procedure can be optimized. The more energy generated by the multi-junction photovoltaic cell, the more electrolysis product is generated which has to be compressed by means of augmenting the power of the compressing unit. As the compressing unit is, next to the electrolysis assembly, a main consumer of electrical energy, it is such possible to obtain a highly autonomous system.

Moreover, by means of the compressing unit, the generated electrolysis product can be further pressurised and thereby fluidised already at the electrolysis assembly. This is applicable especially to basis electrolysis products as well as to higher chemical energy containing electrolysis products. Said pressurization to high levels is especially advantageous for transportation of the electrolysis products, e.g. by means of pipelines or pressurized tank trailers. Additionally, said pressurization to high levels is advantageous for storing the electrolysis product to buffer fluctuations in the production. To this end, the electrolysis assembly preferably comprises a plurality of pressure resistant electrolysis cells, such that the electrolysis product can be generated under pressure. Alternatively or additionally, each of the electrolysis cells comprises a compressor configured to flu-idise the electrolysis product before it is discharged into a collection line or a storage tank. By this means, the need for expensive high-volume-flow compressor stages at the storage assembly may be eliminated.

A further aspect of the invention is a method for generating an electrolysis product with an electrolyser. In particular, said electrolyser is the electrolyser according to the invention.

In order to generate an electrolysis product with the electrolyser, electromagnetic radiation is converted into electrical energy by means of a multi-junction photovoltaic cell. In particular, this multi-junction photovoltaic cell is the multi-junction photovoltaic cell described already above in context with the electrolyser according to the invention. Furthermore, the electrolysis product is generated from a supply medium by means of providing at least a part of the electrical energy generated by said multi-junction photovoltaic cell to an electrolysis assembly via a DC/DC-converter converting a voltage generated by the multi-junction photovoltaic cell directly into an operating voltage of the electrolysis assembly. Especially, said DC/DC converter is the same as the DC/DC converter already described above in context with the electrolyser. Further, said electrolysis assembly is preferably the electrolysis assembly already described in context with the electrolyser according to the invention. In this way, the photovoltaic cell is advantageously directly coupled, e.g. via corresponding interface components, to the electrolysis assembly, wherein the electrical coupling is configured to transmit the electrical energy generated by the multi-junction photovoltaic cell directly into the electrolysis assembly via DC/DC-coupling. This means that no conversion of the generated direct current into an alternating current, and/or no significant transformation of the corresponding electrical voltage between the multi-junction photovoltaic cell and the electrolysis assembly is necessary. Accordingly, in contrast to conventional solutions where electrical energy is transmitted to an electrolyser via a power grid, the provision of electrical energy to the electrolysis assembly gains in efficiency. Furthermore, by using the direct coupling in combination with multi-junction photovoltaic cells a footprint area can significantly be reduced.

By means of the system according to the invention a method for operating the system according to the invention can be realised.

In order to operate the system, energy generated by a multi-junction photovoltaic cell is fed to an external power grid in dependence of a parameter characterizing a state of the electrolyser of the system, of a peripheral module of the system and/or of said external power grid. Alternatively or additionally, the system is operated by drawing electrical energy from the external power grid in dependence of at least one of said parameters in order to operate the electrolyser. For example, said control parameter is any one of the following: a total energy output of the multi-junction photovoltaic cell, an operating state of the external power grid, a market price for electrical power, a prediction of the market price of electrical power, an actual market price, a prediction of illumination and/or weather conditions, an amount of electrical energy stored in the energy storage unit, a maximum electrolysis product production, equipment life-time optimisation, minimum degradation, energy consumption of the electrolyser, optimisation of static pressure level of the electrolysis product, cooling conditions, heat utilisation, optimisation of oxygen usage and/or optimisation of supply by the supply medium. In this way, a reliable, situation-dependent routing of the electrical energy becomes possible. To this end, the system, in particular a control unit of the regulation assembly of the electrolyser, is preferably configured to monitor the control parameter, in particular to test whether the control parameter has reached and/or dropped below and/or exceeded a predetermined threshold. Advantageously, the system, in particular the control unit, is configured to receive data indicatively of the control parameter and to compare it with the corresponding threshold, and to route the electrical energy based on a result of the comparison.

For example, the system distributes the generated electric energy between the electrolysis cells of the electrolysis assembly in such that at least some electrolysis cells may operate at an optimal operation point if the total energy output of the multi-junction photovoltaic cell indicates that not enough energy can be provided to, in particular efficient, operation of all electrolysis cells. For example, the control unit may be configured to check whether the total energy output of the multi-junction photovoltaic cell reaches or falls below a predetermined power threshold and, based on a result of the checking, route electrical energy generated by the multi-junction photovoltaic cell in such that at least some of the electrolysis cells can operate on optimum operating voltage. Thereby, reliable and substantially sustained operation of at least some of the electrolysis cells can be secured.

In a preferred advantageous embodiment, at least one peripheral module of the peripheral assembly is controlled in dependence of a parameter characterizing the state of the electrolyser. In this way, benefit can be drawn from direct correlated energy consumption rates of a corresponding peripheral module and the electrolyser.

Alternatively or additionally, the system routes the generated electric energy to the external power grid if, according to the market price for electrical power, it is economically more attractive to produce electrical power instead of the electrolysis product.

Likewise, it is conceivable that the system routes, based on a prediction for the market price or the actual market price of electrical power, the generated electric energy to the energy storage unit, for example a battery. Accordingly, the stored electric energy is fed into the external power grid, i.e. sold, at a later time when the market price has increased.

Alternatively or additionally, the system routes the generated electric energy to the energy storage unit if a prediction of weather conditions - and therefore the expected generation of electrical energy by the multi-junction photovoltaic cell indicates that the energy generation will be insufficient to satisfy the power requirements of the electrolysis assembly in the (near) future. By this means, a substantially sustained operation of the electrolysis assembly can be secured.

Alternatively or additionally, the system may be configured to provide additional electric energy to selected electrolysis cells if the operating state of said electrolysis cells indicates operation off its optimal operation point. In particular, the system may route the electric energy in a manner such that the electrical voltage applied to this selected electrolysis cell is raised or lowered, respectively. This allows for a particularly sustained and reliable operation of at least a part of the electrolysis assembly.

The properties, features and advantages of the invention described above, as well as the manner in which they are achieved, will be explained in more detail in connection with the figures in the following description of examples. Where appropriate, the same reference signs are used in the figures for the same or corresponding elements of the invention. The examples serve to explain the invention and do not limit the invention to the combinations of features indicated therein, even with respect to functional features. Moreover, any of the features disclosed in the examples below may be considered in isolation and suitably combined with the features of any of the above embodiments and their further aspects.

It is shown in:
- FIG 1: an example of an electrolyser comprising a photovoltaic assembly having a plurality of multi-junction photovoltaic cells and further an illustration of an example of a method for generating an electrolysis product;
- FIG 2: an example of a cross section of a multi-junction photovoltaic cell;
- FIG 3: an example of a system comprising an electrolyser and a peripheral assembly and further an illustration of an example of a method for operating this system.

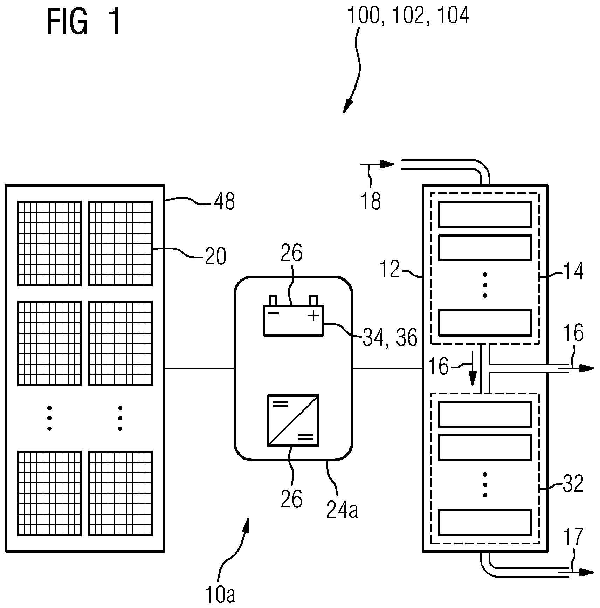

FIG 1 shows a schematic view of a first example of an electrolyser 10a. Further, in FIG 1 an example of a method 100 for generating an electrolysis product 16, 17 is illustrated.

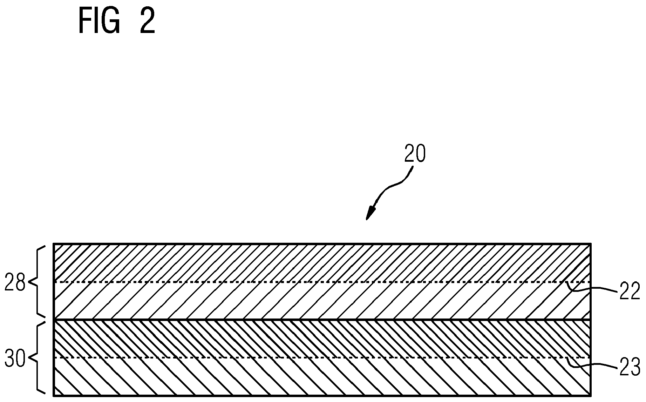

The electrolyser 10a shown in the schematic view of FIG 1 comprises an electrolysis assembly 12 configured to generate an electrolysis product 16 from a supply medium 18. Further, the electrolyser 10a comprises a photovoltaic assembly 48. Said photovoltaic assembly 48 is assembled as a photovoltaic array comprising of a plurality of photovoltaic modules having each multiple multi-junction photovoltaic cells 20. In the present example, all photovoltaic cells of the photovoltaic assembly 48 are multi-junction photovoltaic cells 20. Such a multi-junction photovoltaic cell 20 is made of different semiconductor materials 28, 30 and has multiple p-n junctions 22, 23 by means of which electromagnetic radiation, especially sunlight, is converted into electrical energy. By means of said multi-junction photovoltaic cells 20 more electrical energy can be gained from the sunlight spectra in comparison to single-junction photovoltaic cells made of one semiconductor material having a single p-n junction, e.g. having solely a p-n junction in silicon. Accordingly, multi-junction photovoltaic cells 20 have a higher efficiency in comparison to single-junction photovoltaic cells. Due to this higher efficiency, a footprint area of the electrolyser 10a can be reduced by 10% to 50%, typically by 30%, in comparison to single-junction photovoltaic cells. An example for such a multi-junction photovoltaic cell 20 is shown as a schematic view in FIG 2 and is described in more detail later. Moreover, the example of the electrolyser 10a shown in FIG 1 comprises a regulation assembly 24a. This regulation assembly 24a is directly electrically connected to the photovoltaic assembly 48 and to the electrolysis assembly 12. Further, this regulation assembly 24a is configured to convert at least a part of the electrical energy generated by the multi-junction photovoltaic cells 20 of the photovoltaic assembly48 so as to directly provide an energy supply for the electrolysis assembly 12. For this purpose, the regulation assembly 24a comprises an electric power converter 26. Said electric power converter 26 is exemplary a DC/DC-converter. By means of this DC/DC-converter a voltage generated by the photovoltaic assembly 48 and hence, a voltage generated by each of the multi-junction cells 20 is directly converted 102 into an operating voltage of the electrolysis assembly 12. Further, by means of said DC/DC-converter 26 an electrical current generated by the multi-junction photovoltaic cells 20 is directly converted 102 into an operating electrical current of the electrolysis assembly 12.

In this way, the electrolysis assembly 12 generates 104, upon provision with direct electrical current and voltage generated by the photovoltaic assembly 48, an electrolysis product 16, 17 from a supply medium 18. Accordingly, energy losses due to transportation by means of external power grids and corresponding conversion can be avoided. Thus, the efficiency of the electrolyser 10a can be augmented and in this way and a footprint area of the electrolyser 10a is significantly reduced.

Said supply medium 18 can be water or CO₂, as well as other known molecules suited to be electrochemically split. In the present example, the electrolysis assembly 12 comprises two types of electrolysis cells 14, 32. The first type of said electrolysis cells 14 splits water into H₂ and O₂ or alternatively a mix of CO₂ and water into CO and O₂, small hydrocarbons or small oxygenates. The second type of said electrolysis cells 32 is supplied with the electrolysis product 16 of the first type electrolysis cell 14 and generates 104 an electrolysis product 17 having higher chemical energy than the electrolysis product 16 generated by the first type electrolysis cell 14. Such an electrolysis product 17 having higher chemical energy is for example ammonia, methanol or methane.

Furthermore, the electrolysis cells 14, 32 of the electrolysis assembly 12 of the present example comprises each a proton-exchange membrane. Alternatively, at least one of said electrolysis cells 14, 32 can be an alkaline electrolysis cell and/or comprise an anion-exchange membrane. Further, the electrolysis cells 14, 32 have each a load profile according to which the load of the electrolysis cell 14, 32 is adaptable between a first operating state at 10 % of a power rating of said electrolysis cell 14, 32 and a second operating state at 100 % of the power rating of said electrolysis cell 14, 32 within at least 6 s.

In order to store a part of the electrical energy generated by the photovoltaic assembly 48 the regulation assembly 24a of the electrolyser 10a comprises an energy storage unit 34. By means of said energy storage unit 34 a part of the stored electrical energy can be provided to the electrolysis assembly 12 for example in times of low energy production by the photovoltaic assembly 48. Furthermore, in the present example, the energy storage unit 34 has a buffer module 36 configured to store a part of the electrical energy generated by the multi-junction photovoltaic cells 20 in such that variations in the voltage output of the photovoltaic assembly 48 having a duration time of more than 10 seconds are compensated. An upper limit for compensation of electrical energy supply fluctuations is in the present example about one hour. In this way, short time interruptions or depressions of electromagnetic radiation and hence, short time variations in a supply voltage and/or a supply electrical current can be smoothed. This enables using compact standard components to build up the electrolyser 10a.

FIG 2 shows an example of a multi-junction photovoltaic cell20 in a cross-sectional schematic view. Said example has two p-n junctions 22, 23. The first p-n junction 22 of the two p-n junctions 22, 23 is located in a first semiconductor material 28. The second p-n junction 23 of said two p-n junctions 22, 23 is located in a second semiconductor material30. Said first semiconductor material 28 and said second semiconductor material 30 are chosen as different materials. For example, a semiconductor material is chosen from one of the following materials: perovskite, cadmium telluride (CdTe), copper indium gallium (di)selenide (CIGS), copper indium selenide (CIS), microcrystalline silicon (µc-Si), amorphous Si (a-Si) or quantum dots made from silicon, germanium and/or from compound semiconductors, such as CdSe, PbSe, CdTe and/or PbS. Further, at least one of said semiconductor materials 28, 30 can be provided as a thin film layer having a typical thin film thickness of 1 micrometer to 5 micrometer. In the present example, the first semiconductor material 28 having the first p-n junction 22 comprises crystalline silicon. The second semiconductor material 30 having the second p-n junction 23 comprises perovskite. This applies to all multiple-junction photovoltaic cells 20 of the photovoltaic assembly 48 of the present example. Alternatively, the photovoltaic assembly 48 can comprise a mixture of single-junction photovoltaic cells and multi-junction photovoltaic cells 20. Further, the photovoltaic assembly 48 can comprise different multi-junction photovoltaic cells 20 having different amounts of different semiconductor materials and/or different amounts of p-n junctions located in or between said different semiconductor materials.

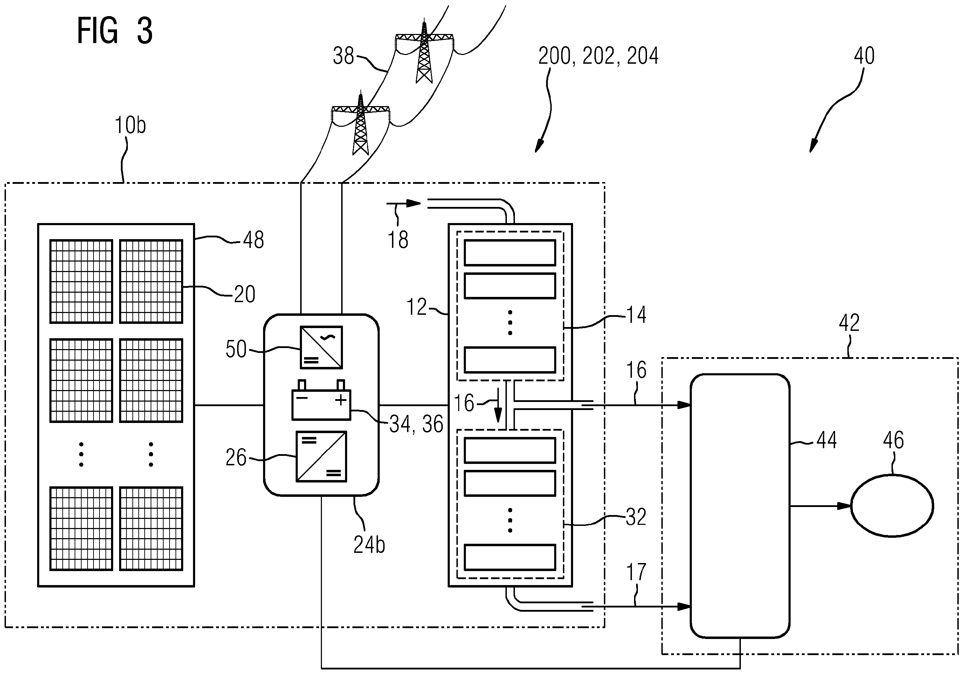

FIG 3 shows an example of a system 40 in a schematic view comprising a second example of an electrolyser 10b and a peripheral assembly 42. Further, FIG 3 illustrates an example of a method 200 for operating the shown system 40.

The electrolyser 10b of the system 40 comprises the same features as the electrolyser 10a described in context with FIG 1. In difference to the first example of the electrolyser10a, the electrolyser 10b of the system 40 is electrically connected to an external power grid 38. Exemplary, this is realised with the help of the regulation assembly 24b containing an interface 50 by means of which at least a part of the electric energy generated by the multi-junction photovoltaic cell 20 is fed 202 to the external power grid 38 and/or drawn 204 from the external power grid 38 in order to operate the electrolysis assembly 12.

Said peripheral assembly 42 comprises a plurality of peripheral modules 44, 46. In the present example, one of the peripheral modules 44, 46 is a compressing unit 44. Said compressing unit 44 is configured to compress the electrolysis product 16, 17. Additionally, a further peripheral module 46 is exemplarily a peripheral storage unit 46 configured to store the gaseous or liquefied electrolysis product 16, 17. Alternative or additional peripheral modules can be for example a chiller unit configured to cool down the compressed electrolysis product 16, 17, a gas cleaning module configured to clean the electrolysis product 16, 17 or a peripheral storage unit configured to store electrical energy. Moreover, in the present example, the compressing unit 44 is operated by means of a part of the electrical energy generated by the photovoltaic assembly 48 of the electrolyser 10b. For this purpose, the regulation assembly 24b of the electrolyser 10b is configured to control said compressing unit 44 in dependence of the electrical voltage and electrical current supplied to the electrolysis assembly 12 via said regulation assembly 24. In this way, the compressing unit 44 is controlled in dependence of an amount of electrical energy generated by the photovoltaic assembly 48.

Moreover, in the present example the regulation assembly 24b is configured to route electrical energy generated from the photovoltaic assembly 48 to the electrolysis assembly 12 or to the external power grid 38 based on at least one control parameter. Further, the regulation assembly 24b is configured to route electrical energy from the external power grid 38 to the system 40 based on said at least one control parameter. Such a control parameter is any one of the following: a total energy output of the multi junction photovoltaic cell, an operating state of the external power grid 38, an actual market price for electrical power, a prediction of the market price of electrical power, a prediction of illumination and/or weather conditions, an amount of electrical energy stored in at least one energy storage unit 34, an amount of stored gas or liquid in the storage unit 46, a maximum electrolysis product 16, 17 production, equipment life-time optimisation, minimum degradation, energy consumption of the electrolyser10b, optimisation of static pressure level of the electrolysis product 16, 17, cooling conditions, heat utilisation, optimisation of oxygen usage and/or optimisation of supply by the supply medium 18. In this way, a reliable, situation-dependent routing of the electrical energy becomes possible.

Although the invention has been further illustrated and described in detail by the above examples, the invention is not limited by the disclosed examples, and other variations may be derived therefrom by those skilled in the art without departing from the scope of the invention.

## Claims

1. An electrolyser (10a, 10b) comprising:
- an electrolysis assembly (12) having an electrolysis cell (14) configured to generate an electrolysis product (16) from a supply medium (18);
- a multi-junction photovoltaic cell (20) having multiple p-n junctions (22); and
- a regulation assembly (24a, 24b) having an electric power converter (26) configured to convert at least a part of the electrical energy generated by the multi-junction photovoltaic cell (20) according to requirements of the electrolysis assembly (12) so as to provide an energy supply for the electrolysis assembly (12).

2. The electrolyser (10a, 10b) according to claim 1, **characterised in that**
the electric power converter (26) is a DC/DC-converter configured to convert a voltage generated by the multi-junction photovoltaic cell (20) directly into an operating voltage of the electrolysis assembly (12).

3. The electrolyser (10a, 10b) according to claim 1 or 2, **characterised in that**
the multi-junction photovoltaic cell (20) comprises perovskite as a semiconductor material (30).

4. The electrolyser (10a, 10b) according to one of the preceding claims,
**characterised in that**
the multi-junction photovoltaic cell (20) comprises at least one semiconductor material (28) from the following group consisting of cadmium telluride (CdTe), copper indium gallium (di)selenide (CIGS), copper indium selenide (CIS), microcrystalline silicon (µc-Si) or amorphous Si (a-Si).

5. The electrolyser (10a, 10b) according to one of the preceding claims,
**characterised in that**
at least one p-n junction (22, 23) of the multi-junction photovoltaic cell (20) is located in a semiconductor material (28, 30) comprising quantum dots.

6. The electrolyser (10a, 10b) according to one of the preceding claims,
**characterised in that**
the multi-junction photovoltaic cell (20) has two p-n junctions (22, 23), wherein a first of said two p-n junction (22) is located in a semiconductor material (28) comprising crystalline silicon and a second of said two p-n junctions (23) is located in a semiconductor material (30) comprising perovskite.

7. The electrolyser (10a, 10b) according to one of the preceding claims,
**characterised in that**
the electrolysis cell (14) has a load profile according to which the load of the electrolysis cell (14) is adjustable between a first operating state at 10% of a power rating of said electrolysis cell (14) and a second operating state at 100% of the power rating of said electrolysis cell (14) within 10s, preferably within 6s and especially preferably within 2 s.

8. The electrolyser (10a, 10b) according to one of the preceding claims,
**characterised in that**
the electrolysis assembly (12) comprises at least one downstream electrolysis cell (32) configured to generate a higher chemical energy containing electrolysis product (17) on the base of a lower chemical energy containing electrolysis product (16).

9. The electrolyser (10a, 10b) according to one of the preceding claims,
**characterised in that**
the regulation assembly (24a, 24b) has an energy storage unit (34) configured to store at least a part of the electrical energy generated by the multi-junction photovoltaic cell (20) and to provide at least a part of the electrical energy stored to the electrolysis assembly (12).

10. The electrolyser (10a, 10b) according to claim 9, **characterised in that**
the energy storage unit (34) has a buffer module (36) configured to store at least a part of the electrical energy generated by the multi-junction photovoltaic cell (20) in such that variations in the voltage output generated by the multi-junction photovoltaic cell (20) having a duration time of more than 10s, preferably more than 30s, are compensated.

11. The electrolyser (10a, 10b) according to one of the preceding claims,
**characterised in that**
the regulation assembly (24a, 24b) is electrically connected to an external power grid (38) and configured to feed at least a part of the electric energy generated by the multi-junction photovoltaic cell (20) to the external power grid (38) and/or to draw electrical energy from the external power grid (38) in order to operate the electrolysis assembly (12).

12. A system (40) comprising:
- an electrolyser (10a, 10b) according to one of the preceding claims;
- a peripheral assembly (42) with a plurality of peripheral modules (44, 46), wherein at least one of these peripheral modules (44) is fed with at least a part of the electrical energy generated by a multi-junction photovoltaic cell (20) of said electrolyser (10a, 10b).

13. The system (40) according to claim 12,
**characterised in that**
- the peripheral assembly (42) comprises a compressing unit (44) configured to compress the electrolysis products (16, 17) generated by the electrolysis assembly (12);
- a regulation assembly (24a, 24b) of the electrolyser (10a, 10b) is configured to control said compressing unit (44) in dependence of an amount of an electrical energy generated by the multi-junction photovoltaic cell (20) and/or in dependence of the electrical voltage supplied to the electrolysis cell (14) via said regulation assembly (24a, 24b).

14. A method (100) for generating an electrolysis product (16) with an electrolyser (10a, 10b), in particular with the electrolyser (10a, 10b) according to any one of claims 1 to 11, the method (100) comprising:
- converting (102) electromagnetic radiation into electrical energy by means of a multi-junction photovoltaic cell (20); and
- generating (104) the electrolysis product (16) from a supply medium (18) by means of providing at least a part of the electrical energy generated by said multi-junction photovoltaic cell (20) to an electrolysis assembly (12) via a DC/DC-converter (26) converting a voltage generated by the multi-junction photovoltaic cell (20) directly to an operating voltage of the electrolysis assembly (12).

15. The method (200) for operating a system (40) according to claims 12 or 13, wherein electrical energy generated by a multi-junction photovoltaic cell (20) is fed (202) to an external power grid (38) and/or electrical energy is drawn (204) from the external power grid (38) in dependence of a parameter characterizing a state of an electrolyser (10a, 10b) of the system (40), of a peripheral module (44, 46) of the system (40) and/or of said external power grid (38) in order to operate the electrolyser (10a, 10b).
